# EUROPEAN PATENT APPLICATION

(11) **EP 4 712 729 A1**
(43) Date of publication of application: **18.03.2026**
(21) Application number: 24200138.6
(22) Date of filing: 13.09.2024
(51) Int. Cl.: H10D 84/01, H10D 30/01, H10D 64/01, H10D 84/83, H10D 84/85

(54) **A METHOD FOR FORMING A SEMICONDUCTOR STRUCTURE**

(71) Applicant: Imec VZW, 3001 Leuven (BE)
(72) Inventor: PETERSEN BARBOSA LIMA, Lucas, 3001 Heverlee (BE); MERTENS, Hans, 3000 Leuven (BE); DEMUYNCK, Steven, 3200 Aarschot (BE); CHAN, Boon Teik, 3012 Wilsele (BE)
(74) Representative: AWA Sweden AB

(57) **Abstract**

The present invention provides a method for forming a semiconductor structure (100), the method comprising:
forming a fin (103) comprising a layer stack (110) on a substrate (102), the layer stack (110) comprising:
a first sub-stack (120) comprising:
at least one channel layer (122)
at least one sacrificial layer (124)

a dielectric layer (132) on top of the first sub-stack (120)

depositing a dummy gate oxide (142) straddling the fin (103), the dummy gate oxide (142) extending over the dielectric layer (132) of the fin (103),
forming a dummy gate (150) on top of the dummy gate oxide (142), the dummy gate (150) straddling the fin (103).

## Description

### TECHNICAL FIELD

The present disclosure relates to a method for forming a semiconductor structure.

### BACKGROUND

High aspect ratio (HAR) refers to the ratio of the height to the width of a structure. In gate patterning, this entails forming gate structures that are substantially taller than they are wide. High aspect ratio (HAR) gate patterning may be used in the fabrication of particularly advanced transistor architectures like the nanosheet (NS), forksheet (FS), and complementary FET (CFET) devices.

### SUMMARY

It is an objective of the present inventive concept to provide an improved method for HAR gate patterning. A further objective is to provide a method with improved etch selectivity. A further objective is to provide a method capable of forming a robust semiconductor structure. Further and alternative objectives may be understood from the following.

According to a first aspect of the invention, there is provided a method for forming a semiconductor structure, the method comprising:
forming a fin comprising a layer stack on a substrate, the layer stack comprising:
   a first sub-stack comprising:
      at least one channel layer
      at least one sacrificial layer
   a dielectric layer on top of the first sub-stack
depositing a dummy gate oxide straddling the fin, the dummy gate oxide extending over the dielectric layer of the fin,
forming a dummy gate on top of the dummy gate oxide, the dummy gate straddling the fin.

The semiconductor structure may be a semiconductor structure for producing a stack of field effect transistors (FETs) comprising a top and bottom FET. The stack of FETs may be a CFET, wherein the top FET is a NFET and the bottom FET is a PFET, or vice versa. Thus, the semiconductor structure may be a semiconductor structure suitable to be converted into a stack of FETs, e.g. a CFET.

Accordingly, the method is compatible with complementary FET (CFET) device fabrication. The method is also compatible with forksheet (FS) device fabrication. The method is also compatible with nanosheet (NS) gate-all-around (GAA) FET device fabrication. The method is also compatible with FinFET device fabrication. The resulting semiconductor structure may be used to produce a stack of FETs.

It should in this context be noted that the use of first, second, etc., are mainly to be seen as labels facilitating reading and that it does not necessarily mean that there needs to be further/all the intervening numbers of portions present. To this end, the layer stack is not limited to one unit of a (first) sub-stack. In fact, the layer stack may comprise more than one sub-stack. For instance, the layer stack may comprise two, three, or more sub-stacks. The sub-stacks may be stacked on top of each other and further be in abutment with each other. At least some of the sub-stacks may comprise at least one channel layer and at least one sacrificial layer. At least some of the sub-stacks may comprise merely sacrificial layers.

By way of example, the layer stack may, as seen along a bottom-up direction (normal to the substrate) comprise a plurality of sub-stacks arranged on top of each other. The layer stack may comprise an uppermost first sub-stack, an intermediate second sub-stack, and a bottommost third sub-stack. The first sub-stack may be arranged on the second sub-stack. The second sub-stack may be arranged on the third sub-stack.

The first sub-stack may, in accordance with the above, comprise a channel layer and a sacrificial layer. Likewise, the third sub-stack may be configured in a similar way as the first sub-stack. The second sub-stack, i.e. the sub-stack that is sandwiched between the first sub-stack and the third sub-stack, may comprise a plurality of sacrificial layers.

The channel layer of the first sub-stack may be a channel layer for a top FET. Similarly, the channel layer of the third sub-stack may be intended to function as a channel layer for a bottom FET. Channel layers may be Si layers. The second sub-stack may be an insulating region separating the top FET and the bottom FET electrically.

Sacrificial layers may be layers intended to be removed by etching selectively said layers to the channel layers in order to form "released" or "suspended" channel layer portions in the layer stack before completion of the device. Such released/suspended channel layer portions may be provided with wrap-around-gates (i.e. GAA). The sacrificial layers may be SiGe layers. The channel layers may be patterned such that the channel layers form nanosheets.

By etching or removing a first feature or material selectivity to a second feature or material is hereby meant that an etch rate of the first feature or material is greater than an etch rate of the second feature or material, when exposed to the selective etching process. Etching or removing a first feature or material selectively to a second feature or material may imply an etch rate ratio of 10:1, 50:1, 100:1 or greater, a greater ratio indicating a greater selectivity.

Sacrificial layers may alternatively/additionally be layers that can be replaced with dielectric material during production of a stack of FETs. In accordance with the above, the dielectric material may then function as electrical isolation, e.g. as isolation between the bottom and top FET. Such electrical isolation between the bottom and top FET may be referred to as middle dielectric isolation (MDI). Accordingly, the dielectric layer as formed on top of the first sub-stack (or any other layers in the first sub-stack that may serve as electrical isolation) may be referred to as top dielectric isolation (TDI). A bottom portion of the semiconductor structure may also serve as an isolating region. Such isolation may be referred to as a bottom dielectric isolation (BDI).

The semiconductor structure may be subject to a (HAR) gate etch process in subsequent semiconductor processing steps in order to form a final gate structure. Accordingly, the dummy gate (sacrificial gate structure) is intended to be replaced by a functional/final gate The dummy gate may be replaced in accordance with a conventional replacement metal gate process. In other words, the (first) dummy gate may be a sacrificial gate structure intended to be replaced by a (second) functional gate structure.

The term "functional gate structure" or "final gate structure" here refers to a gate structure providing the function of a gate in the finished devices. The functional gate structure may comprise a first gate stack (e.g. including a P-type WFM) arranged in the first device region (e.g. a P-type region) and a second gate stack (e.g. including an N-type WFM) arranged in the second device region (e.g. an N-type region). The functional gate structure may be a replacement metal gate structure.

The first aspect of the invention is based on the insight that during gate patterning, the semiconductor structure is subject to gate etch processes. Such gate etch processes may entail challenges such as maintaining the desired aspect ratio and avoiding erosion of the active part of the semiconductor structure.

When the semiconductor structure is subject to erosion, the active part of the semiconductor structure may risk being eroded hence resulting in detrimental electrical performance.

The term "active part" here refers to regions of the semiconductor structure where the electrical properties thereof can be controlled and manipulated to perform functions such as amplification and switching. In this regard, the active part will generally be situated below the gate stack.

Accordingly, it is a realization that the dielectric layer may be designed to be preserved during the gate etch processes and thus prevent, at least partially, erosion of the active part of the semiconductor structure. The dielectric layer may have such a thickness/comprise a material to prevent erosion of the active part while still enabling e.g. a reduced gate leakage current. Hence, a robust electrical stability may be ensured.

By virtue of the dielectric layer preventing erosion of the active part of the semiconductor structure, there is also provided an improved etch selectivity. The dielectric layer ensures that removal of material during gate etch does not extend to portions of the semiconductor structure that need not be removed, i.e. the active portion. Instead, the etchant as used in the gate etch will primarily etch the dummy gate.

The first aspect of the invention is also based on the insight that finalizing the semiconductor structure may comprise releasing/suspending channel layers of the semiconductor structure and thereby forming recesses between adjacent released/suspended channel layers. In order to form a gate stack, processing steps may involve filling the resulting recesses surrounding the released/suspended channels with a work function metal hence forming wrap-around-gates.

It is a realization that the dummy gate oxide may be designed so as to facilitate the release of the channel layers. A thickness of the dummy gate oxide may be chosen to facilitate the removal of sacrificial layers surrounding channel layers while also preventing, at least partially, erosion of the active part of the semiconductor structure. Hence, the dielectric layer and the dummy gate oxide may, in unison, prevent erosion of the active part of the semiconductor structure and thus ensure an improved etch selectivity and a robust electrical stability.

By the wording "a first layer arranged on a second layer" in reference to any of the layers (or layers of the sub-stack) of the layer stack is hereby meant that the first layer is arranged directly on (i.e. in abutment with) the second layer.

Relative spatial terms such as "topmost", "bottom", "lower", "vertical", "stacked on top of", are herein to be understood as denoting locations or directions within a frame of reference of the semiconductor structure. In particular, the terms may be understood in relation to a normal direction to the substrate on which the layer stack is formed, or equivalently in relation to a bottom-up/stacking direction of the layer stack. Correspondingly, terms such as "lateral" and "horizontal" are to be understood as locations or directions parallel to the substrate.

The term "thickness" is to be understood as a dimension of a structure (e.g. a layer of a sub-stack) as seen along a normal to a surface underlying the structure (e.g. the layer of the sub-stack). For example, the thickness of a layer of the layer stack, or the thickness of the sub-stack, may refer to the thickness dimension of the layer/sub-stack as seen along the bottom-up/stacking direction of the layer stack.

When this text refers to opposite ends of the layer stack, it can be understood that said opposite ends may be the ends where source/drain regions are to be formed. It may also be understood that said opposite ends may be opposite sides of a gate structure.

A thickness of the dielectric layer may be in a range of 0.5 - 10 nm.

By way of example, the thickness of the dielectric layer may be 0.5, 1, 2, 3, 4, 5, 6, 7, 8, 9, or 10 nm. Such a thickness of the dielectric layer provides sufficient protection of the active part of the semiconductor structure during gate etch processes, while simultaneously providing a semiconductor structure being comparably thin. This enables further device scaling. Also, a reduced growth thickness of the dielectric layer may enable a reduced amount of growth defects of the layer stack.

A thickness of the dummy gate oxide may be in a range of 0.5 - 8 nm.

By way of example, the thickness of the dummy gate oxide may be 0.5, 1, 2, 3, 4, 5, 6, 7 or 8 nm. Such a thickness of the dummy gate oxide facilitates the removal of sacrificial layers surrounding channel layers while also preventing, at least partially, erosion of the active part of the semiconductor structure.

It is a realization that a dummy gate oxide that is comparably thick may result in undercut during gate etch processes. Hence, by the thickness of the dummy gate oxide being in the range of 0.5 - 6 nm, the dummy gate oxide is sufficiently thin such that the risk for undercut of the layers of the layer stack is mitigated during gate etch processes.

The dielectric layer may comprise at least one of: SiN, SiCN, SiOC, SiOCN, Si₃N₄, SiOBCN. Thus, the dielectric layer may comprise SiN and/or SiCN and/or SiOC and/or SiOCN, and/or Si₃N₄, and/or SiOBCN.

SiN, SiCN, SiOC, SiOCN, Si₃N₄, and SiOBCN are suitable materials for the dielectric layer. By the dielectric layer comprising SiN, SiCN, SiOC, SiOCN, Si₃N₄, and/or SiOBCN, the dielectric layer prevents erosion of the active portion of the semiconductor structure during gate etch. It should be noted that SiOBCN is merely one example of a boron-doped material and it is conceivable that the dielectric layer may comprise any suitable boron-doped material other than SiOBCN.

The dummy gate oxide may comprise SiO₂.

By the dummy gate oxide comprising SiO₂, improved etch selectivity is provided. It is further advantageous that the dummy gate oxide comprises a different material from that of the dielectric layer.

As noted above, formation of the finalized semiconductor structure may comprise releasing channel layers of the semiconductor structure in the sense that sacrificial layers surrounding channel layers are replaced. By the dummy gate oxide being different from the dielectric layer material wise, improved etch selectivity is introduced. This will, in turn, facilitate release of the channel layers during processing of the semiconductor structure.

The dummy gate may comprise amorphous Si, a-Si, or polycrystalline Si, poly-Si.

By the dummy gate comprising a-Si or Poly-Si, removal of the dummy gate is facilitated.

Forming the fin may comprise
forming the first sub-stack; and
forming the dielectric layer on top of the first sub-stack; and,
etching out the fin from the first sub-stack and the dielectric layer such that said act of etching out the fin is performed subsequent to the act of forming the dielectric layer.

Forming the fin and the dielectric layer in sequence may facilitate forming a plurality of fins with improved uniformity, and reduce the amount of processing steps.

The method may further comprise the steps of:
depositing a liner material on side surfaces of the layer stack by conformal coating;
depositing an oxide fill material at opposite sides of the layer stack; and
forming recesses at opposite sides of the layer stack by etching the oxide fill material and removing exposed liner material by selective isotropic etching.

It should be noted in this context that the act of depositing a liner material on side surfaces of the layer stack may also entail depositing the liner material on top of the layer stack or on a top surface of the layer stack, e.g. such that the liner material is in direct contact with the dielectric layer.

Selective isotropic etching of the exposed liner material allows for a controlled removal of the liner material. This ensures that portions of the active portion are not removed during etching of the liner material. This will in turn enable a uniform deposition of the dummy gate oxide at opposite sides of the layer stack. As such, this facilitates subsequent processing steps e.g. formation of the gate stack.

It is conceivable that any suitable dry etching process or wet etching process allowing selective etching of the liner material may be used (e.g. HCl, or APM).

The oxide fill material may be removed to such an extent that a level of the remaining oxide fill material is situated below the active part of the semiconductor structure. For instance, that level may be below a lowermost channel of the semiconductor structure, and even further below a lowermost bottom dielectric isolation. To this end, etching of the liner material may be performed to such an extent that the remaining liner material is also level/flush with the remaining oxide fill material.

The liner material may comprise Si₃N₄, SiOC, or a-Si.

The material of the liner material generally differs from the material of the dielectric layer in order to facilitate etch selectivity. By way of example, the liner material may comprise Si₃N₄, while the dielectric layer may comprise any one of SiN, SiCN, SiOC, SiOCN and SiOBCN. By way of another example, the liner material may comprise SiOC, in which case the dielectric layer may comprise any one of SiN, SiCN, SiOCN, Si₃N₄, and SiOBCN. By way of another example, the liner material may comprise a-Si, in which case the dielectric layer may comprise any one of SiN, SiCN, SiOC, SiOCN, Si₃N₄, and SiOBCN.

To illustrate, consider a situation where the liner material and the material of the dielectric layer is identical. Any etch process (e.g. for the purpose of forming shallow-trench-insulation (STI) regions in the substrate) entails using an etchant which may effectively etch both the liner material and the dielectric layer (the etch rate being the same for both the liner material and the dielectric layer). To this end, the liner material and the dielectric layer will be reduced. However, by the dielectric layer being reduced there may be a risk that the dielectric layer may not be preserved during a subsequent full gate etc process. Such a gate etch process may entail subjecting the semiconductor structure to an etchant selective to the dummy gate. However, if the dielectric layer is rendered thin, perhaps due to erosion stemming from any preceding etch processes, the gate etch process may erode the remaining dielectric layer and consequently erode the underlying active portion of the semiconductor structure. However, by employing a liner material being different from the dielectric layer, an etchant may be used in order to etch the liner material selectively while etching of the dielectric layer is minimized. Thus, etch selectivity is improved and the dielectric layer may be preserved during etch processes.

By virtue of this, during formation of the gate stack of the semiconductor structure, the active portion of the semiconductor structure may be protected by the dielectric layer to a larger extent compared to had the liner material and dielectric layer been formed of the same material.

The oxide fill material may comprise SiO₂, or SiOC.

By the oxide fill material comprising SiO₂, or SiOC, the oxide fill material is comparably easy to implement during processing of the semiconductor structure (e.g. formation of shallow-trench-insulation (STI) regions in the substrate).

The act of depositing the oxide fill material is performed by flowable chemical vapor deposition.

This enables forming high-quality isolating portions of the semiconductor structure.

The method may further comprise depositing a spin-on carbon, SoC, coating on opposite sides of the layer stack, the SoC coating being deposited between the acts of depositing the liner material and depositing the oxide fill material;
etching the liner material thereby exposing a top portion of the layer stack and removing the SoC coating while portions of the liner material in contact with the SoC coating are preserved.

Processing of the semiconductor structure conventionally involves one or more etch processes. The spin-on carbon may act to serve as a protecting coating with respect to a bottom portion of the semiconductor structure. More specifically, the spin-on carbon may protect a bottom portion of the liner material during subsequent etching of the semiconductor structure, hence ensuring that the liner material in the bottom portion of the semiconductor structure is not subject to erosion. In doing so, a robust electrical stability is maintained. Also, by ensuring that the liner material is not subject to erosion, uniformity of the liner material is maintained which will further facilitate subsequent processing steps.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

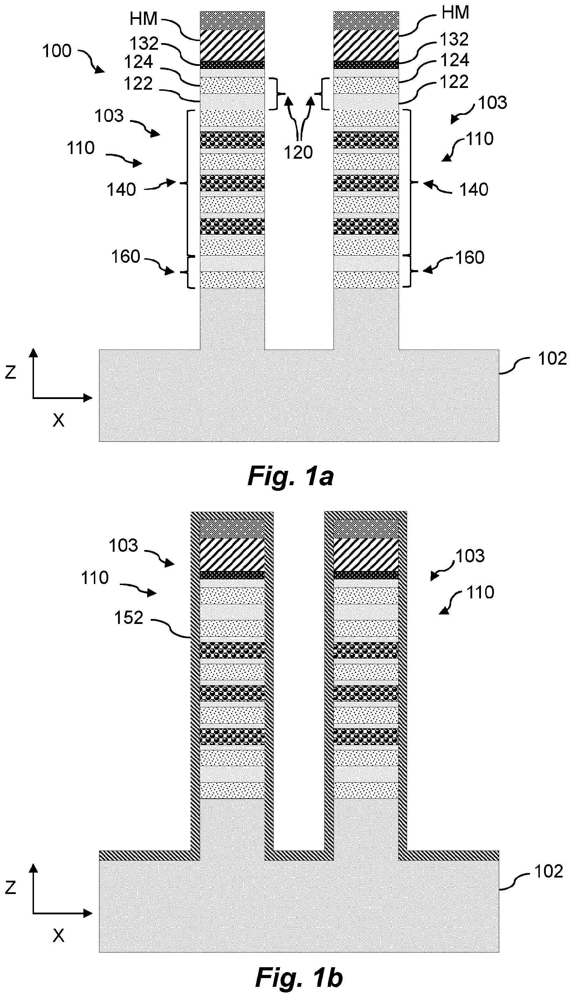

Figs. 1a-ee illustrate the semiconductor structure formation steps of a method in a schematically depicted cross-sectional view.

### DETAILED DESCRIPTION

In the following the formation of a semiconductor structure will be exemplified in the context of a CFET. It should be understood that the figures schematically represent the semiconductor structure and that the respective gate dielectric of the NFET and PFET of the CFET may for instance be electrically insulated from each other by e.g. a dielectric wall.

Referring now to Fig. 1a, an initial semiconductor structure 100 is illustrated. The semiconductor structure 100 may be formed on a substrate 102. The substrate 102 may be a conventional semiconductor substrate suitable for e.g. complementary metal-oxide semiconductor (CMOS). The substrate 102 may for instance be a semiconductor bulk substrate such as a Si substrate, a germanium (Ge) substrate or a silicon-germanium (SiGe) substrate. Other examples include a semiconductor-on-insulator (SOI) type of substrate such as a Si-on-insulator substrate, a Ge-on-insulator substrate, or a SiGe-on-insulator substrate.

The method may further comprise planarizing a top surface of the substrate 102. A smooth top surface of the substrate 102 may thus be formed. As such, the substrate 102 may provide a flat top surface which facilitates forming a layer stack on top of the substrate 102.

Whenever there is a reference to a layer being formed, this is preferably performed using conventional semiconductor fabrication technology, such as metalorganic chemical vapour deposition (MOCVD), physical vapor deposition (PVD), atomic layer deposition (ALD), thin-film deposition, or the like. The layers may be formed in an epitaxy process.

In the figures, directions X and Z indicate a horizontal and a vertical direction, respectively. Direction Z indicates a vertical or bottom-up direction (normal to the substrate 102). A second (non-illustrated) horizontal direction Y is perpendicular to the plane formed by the horizontal direction X and the vertical direction Z. In the finished FET, the current may flow in the Y direction.

Prior to forming a number of fins 103, an initial layer stack is formed on the substrate 102. The initial layer stack is formed by forming a number of layers on the substrate 102. Each layer may be epitaxially grown. Forming of the initial layer stack may comprise forming at least a first sub-stack 120. Forming the initial layer stack may also comprise forming additional sub-stacks, in this case sub-stacks 140,160. Forming the initial layer stack may also comprise forming a dielectric layer 132. In this context it should be noted that any subsequent processing steps involving patterning of the initial layer stack such that a number of fins 103 is formed, then those fins 103 are to be construed as also comprising any layers that was present in the initial layer stack.

As illustrated in Fig. 1a, the initial layer stack has been patterned to form a number of fins 103. It may in this context be noted that forming the fins 103 comprises etching out each fin 103 from the initial layer stack, or more specifically, from the first sub-stack 120, sub-stacks 140, 160, and the dielectric layer 132. Hence, the step of etching out each fin 103 is performed subsequent to the act of forming the dielectric layer 132. Each fin 103 forms a respective layer stack 110. It should in this context be noted that the term "layer stack" is intended to denote a patterned layer stack portion of the initial layer stack. Each fin 103 may as shown be patterned by etching the initial layer stack while using a hard mask HM as an etch mask. Example etching processes for the fin patterning include anisotropic etching (top-down) like reactive ion etching (RIE). The etching of the initial layer stack may as shown extend into the substrate 102. The substrate 102 may thus be recessed adjacent the fin 103 such that a base portion of each fin 103 is formed in the substrate 102. Recessing the substrate 102 in this manner may accommodate for a thicker bottom isolation underneath source, drain, and gate bodies.

The hard mask HM may be formed by a mask material deposited on the initial layer stack and then patterned. Example mask materials include nitride materials such as SiN, or another conventional hard mask material suitable for fin patterning, e.g. SiO2 or a-Si. Example patterning techniques for the hard mask HM include single-patterning techniques, e.g. lithography and etching, and multiple patterning techniques, e.g. self-aligned double or quadruple patterning (SADP or SAQP).

The figures depict the hard mask HM as comprising two mask portions, implying that two fins 103 has been formed. The two fins 103 may for example be used to form a complementary pair of FET devices, e.g. an n-type FET and a p-type FET. As may be appreciated, mask portions may however be formed in a number corresponding to the number of fins 103 to be formed. In any case, a mask portion of the hard mask HM may remain on each fin 103 as a capping during subsequent stages of the method. However, as illustrated in Fig. 1a, there may be arranged on the hard mask HM a separate capping layer.

A width dimension, a length dimension, and a height dimension of each fin structure 103 is respectively oriented along the first horizontal direction X, the second (non-illustrated) horizontal direction Y and the vertical direction Z, in relation to the substrate 102. As noted above, the second horizontal direction Y is perpendicular to the plane formed by the horizontal direction X and the vertical direction Z. The semiconductor structure 100 may form part of a FET device. In such a case, the second horizontal direction Y corresponds to a channel direction of the FET device, i.e. a direction along which current flows between source and drain bodies when the FET device is in an active state.

The layer stack 110 as illustrated in the figures comprises a plurality of sub-stacks arranged in the bottom-up direction. The layer stack 110 comprises a first sub-stack 120, a second sub-stack 140, and a third sub-stack 160. The first sub-stack 120 comprises a channel layer 122 and a sacrificial layer 124. The channel layer 122 may be a Si layer. The sacrificial layer 124 may be a SiGe layer. Likewise, the third sub-stack 160 may be configured in a similar way as the first sub-stack 120. In other words, the third sub-stack 160 may comprise a channel layer and a sacrificial layer. The second sub-stack 140, i.e. the sub-stack that is sandwiched between the first sub-stack 120 and the third sub-stack 160, may comprise a plurality of sacrificial layers as known per the art.

The layer stack 110 further comprises a dielectric layer 132 on top of the first sub-stack 120. The dielectric layer 132 forms a layer arranged on a surface of the first sub-stack 120 and parallel therewith. The dielectric layer 132 is configured to be arranged in contact with the first sub-stack 120. It is, however, conceivable that there may be arranged an intermediate layer between the dielectric layer 132 and the first sub-stack 120. Such a layer may, for instance, be a layer of Si.

It should in this context be noted that the layer stack 110 as illustrated in the figures need not comprise the second sub-stack 140 and the third sub-stack 160. An alternative layer stack 110 may comprise merely the first sub-stack 120 arranged on the substrate 102. An intermediate layer may be arranged between the substrate 102 and the first sub-stack 120, such as a dielectric layer. Hence, it is implied that the channel layer 122 of the first sub-stack 120 may be in direct contact with the semiconductor substrate 102, or in indirect contact should there be any intermediate layers arranged between the channel layer 122 and the semiconductor substrate 102.

The dielectric layer 132 is a layer of dielectric material. The dielectric layer 132 may comprise SiN, SiCN, SiOC, SiOCN, and/or Si₃N₄.

A thickness of the dielectric layer 132 may be in the range of 0.5 - 10 nm. By way of example, the thickness of the dielectric layer may be 0.5, 1, 2, 3, 4, 5, 6, 7, 8, 9, or 10 nm.

The act of etching out the fins 103 may be performed subsequent to the act of forming the dielectric layer 132.

Each illustrated fin may be used to form a stack of FETs, e.g. a CFET, from. The channel layer of the first sub-stack 120 may form a channel layer of a top FET in such a stack of FETs. The channel layer of the third sub-stack 160 may form a channel layer of a bottom FET in such a stack of FETs. The second sub-stack 140 may be converted into middle dielectric isolation in such a stack of FETs. The following processing steps may be seen as part of the process of forming the above-mentioned stack of FETs.

Referring now to Fig. 1b, the method may further comprise depositing a liner material 152 on side surfaces of the layer stack 110. The deposition of the liner material 152 may be performed by conformal deposition. The liner material 152 may be conformally deposited, e.g. using atomic layer deposition (ALD). It should be noted in this context that the act of depositing a liner material 152 on side surfaces of the layer stack 110 may also entail depositing the liner material 152 on top of the layer stack 110, e.g. such that the liner material 152 is in direct contact with a top layer of the respective layer stack 110. The liner material 152 may also be deposited on exposed portions of a bottom region of the substrate 102.

The liner material 152 may be formed of a dielectric material, e.g. an oxide, a nitride or another low-k dielectric. By way of example, the liner material 152 may comprise Si₃N₄, SiOC, or a-Si.

The liner material 152 may among others mask the fin 103 from subsequent process steps, such as the formation of an oxide layer (which may form part of shallow-trench-insulation (STI) regions in the substrate 102) on opposite sides of the fin 103.

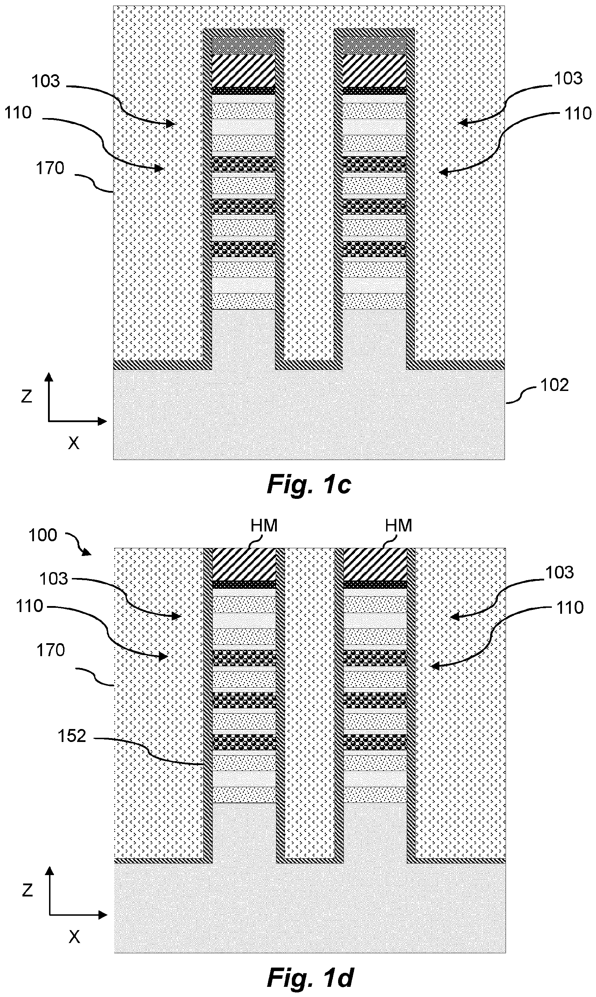

Referring now to Fig. 1c, the method may further comprise depositing an oxide fill material 170, at opposite sides of the layer stack 110. The oxide fill material 170 may form part of isolation regions of the substrate 102. For instance, the substrate 102 may, as noted above, comprise shallow-trench-insulation (STI) regions surrounding the fins 103. STI regions in the substrate 102 may be formed in a manner which per se is known in the art, e.g. by patterning STI trenches in the substrate 102 and filling the STI trenches with an oxide (oxide fill material 170). The oxide may comprise a dielectric, e.g. an oxide such as SiO₂. The STI trenches may for example be formed in a patterning step of the overall patterning process used for forming the fins 103. The act of depositing the oxide may be performed by flowable chemical vapor deposition (FCVD). In this case, the oxide fill material 170 may be deposited to such an extent that the oxide fill material 170 covers the fins 103 and also such that a portion of the oxide fill material 170 extends above the fins 103.

Referring now to Fig. 1d, the method may further comprise planarizing a top surface of the semiconductor structure 100, e.g. using chemical mechanical polishing (CMP). More specifically, any oxide fill material 170 that extends above the fins 103 may be planarized and thus be reduced. To this end, any portion of the liner material 152 that is arranged on top of the respective fin 103 may also be reduced. In this case, liner material 152 arranged on top of the respective fin 103 has been completely removed. In doing so, the oxide fill material 170 is flush with an upper surface of the hard mask HM.

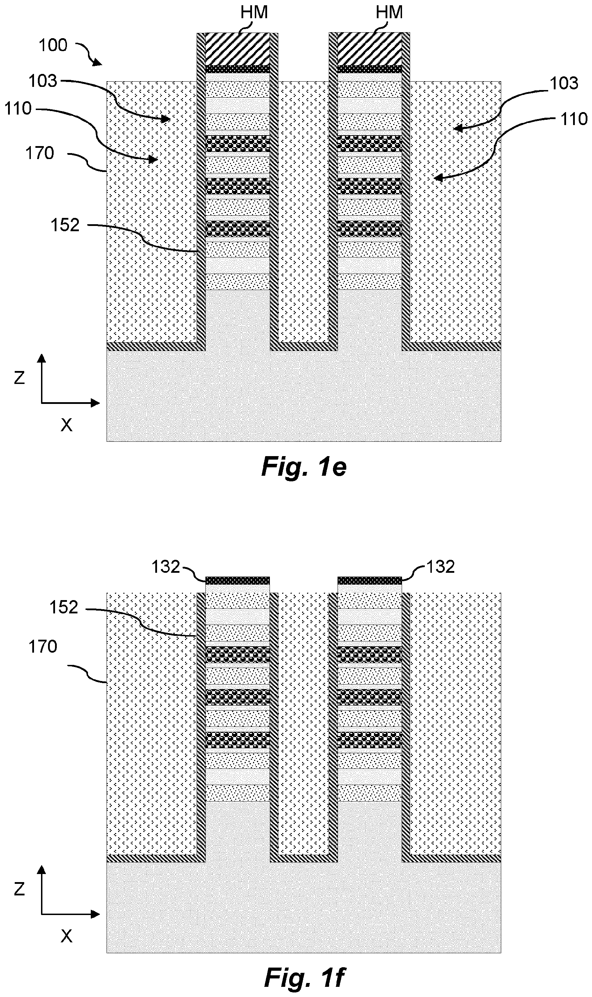

Referring now to Fig. 1e, the method may further comprise further recessing (e.g. by etch-back) the semiconductor structure 100. By way of example, the method may further comprise etching the semiconductor structure 100 such that the oxide fill material 170 is recessed. In doing so, recesses at opposite sides of the respective fin 103 are formed while exposing outer side portions of the liner material 152.

Referring now to Fig. 1f, the method may further comprise etching exposed liner material 152 and the hard mask HM such that the dielectric layer 132 is exposed. In other words, the hard mask HM is completely removed. Etching the exposed liner material 152 and the hard mask HM may be performed by means of hot phosphoric acid, H₃PO₄.

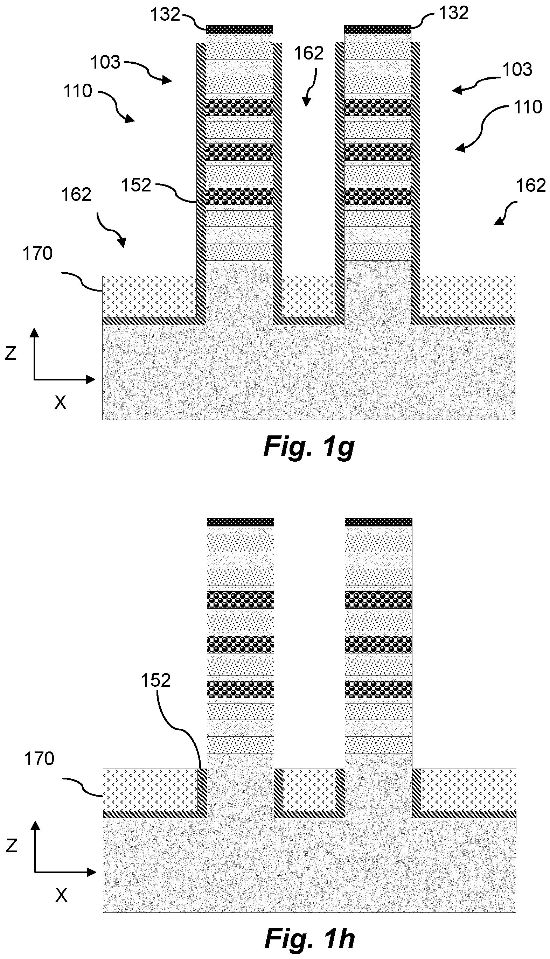

Referring now to Fig. 1g, the method may comprise forming further (deeper) recesses/trenches 162 at opposite sides of the layer stack 110 by etching the oxide fill material 170. The dielectric layer 132 may be used as a masking layer when etching the oxide fill material 170. Example etching processes for forming the recesses 162 include anisotropic etching (top-down) like RIE as well as isotropic (wet or dry) etching.

Depending on the etch contrast between the liner material 152 and the oxide fill material 170, at least a portion of the liner material 152 may be removed from side surfaces of the respective fin 103 during the etching of the oxide fill material 170. However, it is conceivable that a separate dedicated (e.g. isotropic) etch step may be used to remove the liner material 152, as will be described in the following.

Referring now to Fig. 1h, the method may further comprise removing exposed liner material 152 by selective isotropic etching, had the liner material 152 already not been removed from the preceding act of etching the oxide fill material 170. The exposed liner material 152 may be etched to such an extent that the remaining liner material 152 is level with the oxide fill material 170.

Selective isotropic etching of the exposed liner material 152 allows for a controlled removal of the liner material 152. As such, this facilitates subsequent processing steps e.g. formation of the gate stack.

It is conceivable that any suitable dry etching process or wet etching process allowing selective etching of the liner material 152 may also be employed for this purpose (e.g. HCl). A further example is selective etching using an ammonia-peroxide mixture (APM). It should be noted that if the liner material 152 comprises SiN, etching thereof may be performed by means of hot phosphoric acid, H₃PO₄.

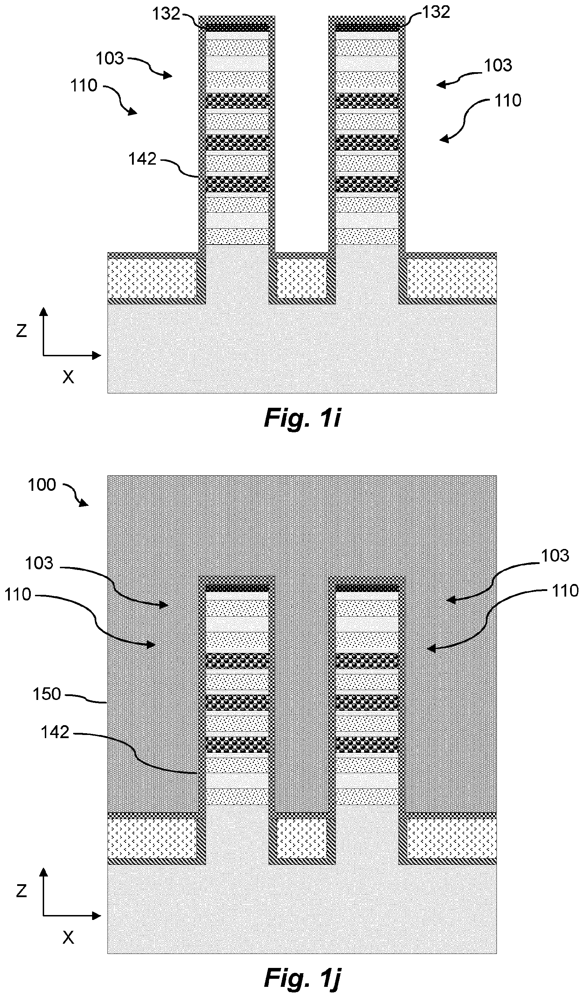

Referring now to Fig. 1i, the method further comprises depositing a dummy gate oxide 142. The dummy gate oxide 142 straddles the fins 103. The dummy gate oxide 142 extends over the dielectric layer 132. The dummy gate oxide 142 further extends along opposite sides of the respective fin 103. The dummy gate oxide 142 extends on top of the oxide fill material 170 and exposed liner material 152. The dummy gate oxide 142 may be said to form a uniform, continuous layer on top of the semiconductor structure 100 and further embedding each of the fins 103.

The dummy gate oxide 142 may be deposited in accordance with a method as known per the art. For instance, the dummy gate oxide 142 may be deposited by conformal coating (e.g. ALD). The dummy gate oxide 142 may alternatively be deposited in accordance with a non-conformal deposition.

The dummy gate oxide 142 may comprise SiO₂. However, the dummy gate oxide 142 is not limited to comprising SiO₂. The dummy gate oxide 142 may comprise any other material as long as that material allows for sufficient etch selectivity.

A thickness of the dummy gate oxide 142 may be in a range of 0.5 - 8 nm

By way of example, the thickness of the dummy gate oxide 142 may be 0.5, 1, 2, 3, 4, 5, 6, 7 or 8 nm. Such a thickness of the dummy gate oxide 142 facilitates the removal of sacrificial layers surrounding channel layers while also preventing, at least partially, erosion of the active part of the semiconductor structure 100.

It is a realization that a dummy gate oxide 142 that is redundantly thick may result in undercut during gate etch. Hence, by the thickness of the dummy gate oxide 142 being in the range of 0.5 - 8 nm, the dummy gate oxide 142 is sufficiently thin such that the risk for undercut of the layers of the layer stack 110 is mitigated during subsequent gate etch.

The dummy gate oxide 142 may form a support structure supporting or tethering the fins 103, thus counteracting collapse of the fins 103 during and after release of the channel layers.

Referring now to Fig. 1j, the method further comprises forming a dummy gate 150 on top of the dummy gate oxide 142. The dummy gate 150 straddles the fin 103. Formation of the dummy gate 150 may comprise a gate etch process.

The semiconductor structure 100 may further be subject to a gate etch process in subsequent semiconductor processing steps in order to form a final gate structure. Accordingly, the dummy gate 150 (sacrificial gate structure) is intended to be replaced by a functional/final gate. The dummy gate may be replaced in accordance with a conventional replacement metal gate process. In other words, the (first) dummy gate may be a sacrificial gate structure intended to be replaced by a (second) functional gate structure.

Generally, the processing steps for forming the semiconductor structure 100 may vary. For instance, the sequence of some of the steps may vary. Some steps may alternatively/additionally be omitted.

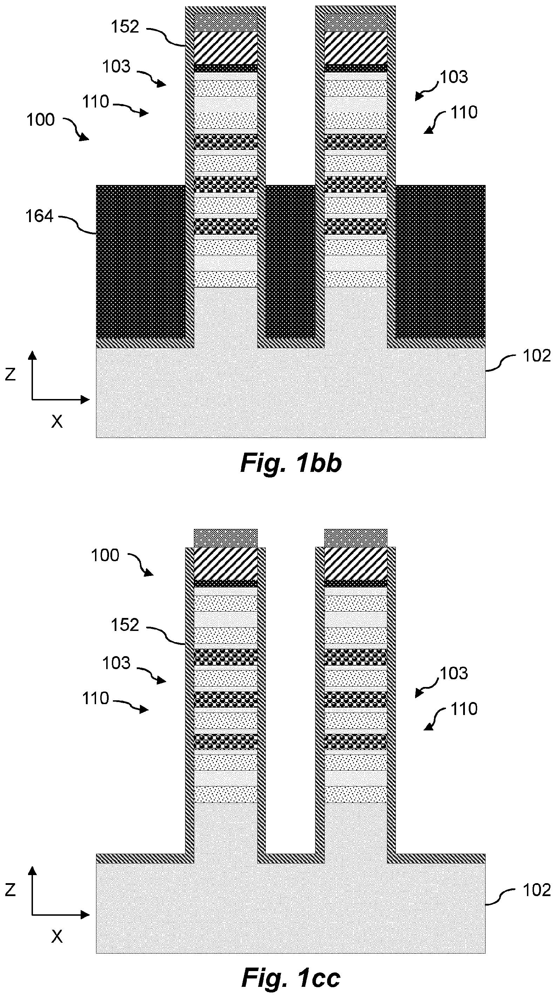

Referring to Fig. 1bb, instead of proceeding directly to depositing an oxide fill material 170 subsequent to depositing the liner material 152, the method may comprise depositing a spin-on carbon, SoC, coating 164 on opposite sides of each of the layer stacks 110. That is, the act of depositing the SoC coating 164 may be performed prior to the act of depositing the oxide fill material 170.

Referring now to Fig. 1cc, the semiconductor structure 100 is subjected to an etch process during which the liner material 152 is etched. In doing so, a top portion of the liner material 152 is removed thereby exposing a top portion of the layer stack 110. Simultaneously, the SoC coating 164 is removed. However, it is conceivable that a separate dedicated etch step is used to remove any remaining SoC coating 164.

Portions of the liner material 152 that was embedded in the SoC coating 164 are preserved during etching of the liner material 152.

The SoC coating 164 may act to serve as a protecting coating with respect to a bottom portion of the semiconductor structure 100. More specifically, the SoC coating 164 may protect a bottom portion of the liner material 152 during subsequent etching of the semiconductor structure 100, hence ensuring that the liner material 152 is not subject to erosion. As discussed above, the liner material 152 may form part of STI regions of the substrate 102. Hence, the step of providing a SoC coating 164 may ensure that robust STI regions are provided in the substrate 102. Also, by ensuring that the liner material 152 is not subject to erosion, uniformity of the liner material 152 is maintained which will further facilitate subsequent processing steps.

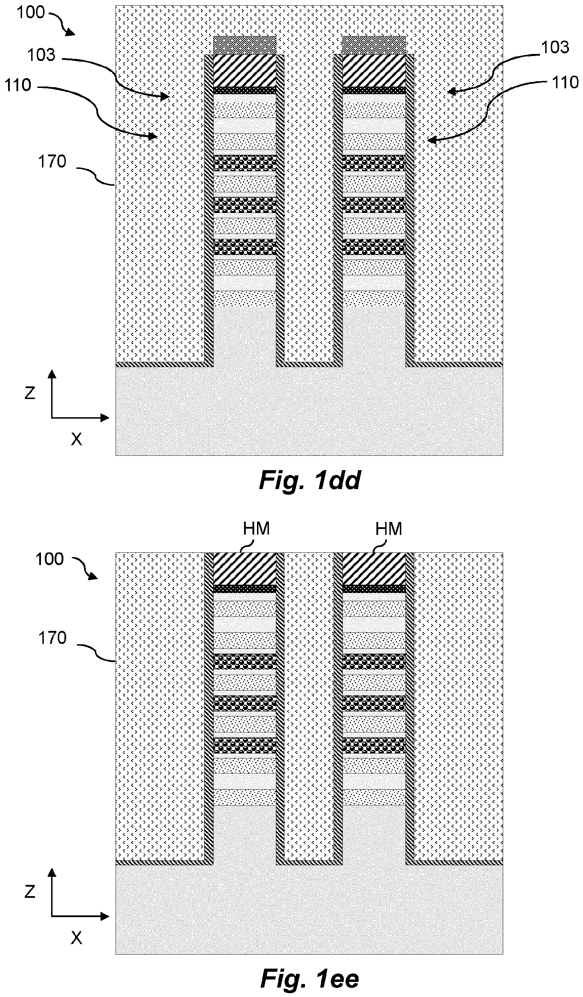

Referring now to Fig. 1dd, the method may further comprise depositing an oxide fill material 170 at opposite sides of the layer stack 110.

Referring now to Fig. 1ee, the method may further comprise planarizing a top surface of the semiconductor structure 100, e.g. using CMP. In doing so, the oxide fill material 170 is flush with an upper surface of the hard mask HM.

Subsequent processing steps may comprise the steps in accordance with the method as disclosed above in various levels of details.

The layers of the semiconductor device as illustrated in the figures may be formed of the materials as discussed in various levels above. Preferably, the channel layer is formed of Si, the dielectric layer 132 of any one of SiN, SiCN, SiOC, SiOCN, and Si₃N₄, the dummy gate oxide 142 of SiO₂, the dummy gate of any one of amorphous Si, a-Si, or polycrystalline Si, poly-Si.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor structure (100), the method comprising:
forming a fin (103) comprising a layer stack (110) on a substrate (102), the layer stack (110) comprising:
a first sub-stack (120) comprising:
at least one channel layer (122)
at least one sacrificial layer (124)
a dielectric layer (132) on top of the first sub-stack (120)
depositing a dummy gate oxide (142) straddling the fin (103), the dummy gate oxide (142) extending over the dielectric layer (132) of the fin (103),
forming a dummy gate (150) on top of the dummy gate oxide (142), the dummy gate (150) straddling the fin (103).

2. A method according to any one of the preceding claims, wherein a thickness of the dielectric layer (132) is in a range of 0.5 - 10 nm.

3. A method according to any one of the preceding claims, wherein a thickness of the dummy gate oxide (142) is in a range of 0.5 - 8 nm.

4. A method according to any one of the preceding claims, wherein the dielectric layer (132) comprises at least one of: SiN, SiCN, SiOC, SiOCN, Si₃N₄, SiOBCN.

5. A method according to any one of the preceding claims, wherein the dummy gate oxide (142) comprises SiO₂.

6. A method according to any one of the preceding claims, wherein the dummy gate (150) comprises amorphous Si, a-Si, or polycrystalline Si, poly-Si.

7. A method according to any one of the preceding claims, wherein forming the fin (103) comprises
forming the first sub-stack (120); and
forming the dielectric layer (132) on top of the first sub-stack (120); and,
etching out the fin (103) from the first sub-stack (120) and the dielectric layer (132) such that said act of etching out the fin (103) is performed subsequent to the act of forming the dielectric layer (132).

8. A method according to claim 7, further comprising the steps of:
depositing a liner material (152) on side surfaces of the layer stack (110) by conformal coating;
depositing an oxide fill material (170) at opposite sides of the layer stack (110); and
forming recesses (162) at opposite sides of the layer stack (110) by etching the oxide fill material (170) and removing exposed liner material (152) by selective isotropic etching.

9. A method according to claim 8, wherein the liner material (152) comprises Si₃N₄, SiOC, or a-Si.

10. A method according to one of claims 8-9, wherein the oxide fill material (170) comprises SiO₂, or SiOC.

11. A method according to one of claims 8-10, wherein the act of depositing the oxide fill material (170) is performed by flowable chemical vapor deposition.

12. A method according to any one of claims 8-11, further comprising
depositing a spin-on carbon, SoC, coating (164) on opposite sides of the layer stack (110), the SoC coating (164) being deposited between the acts of depositing the liner material (152) and depositing the oxide fill material (170);
etching the liner material (152) thereby exposing a top portion of the layer stack (110) and removing the SoC coating (164) while portions of the liner material (152) in contact with the SoC coating (164) are preserved.
